# EUROPEAN PATENT SPECIFICATION

(11) **EP 4 270 632 B1**
(45) Date of publication and mention of the grant of the patent: **28.01.2026**
(21) Application number: 20966855.7
(22) Date of filing: 22.12.2020
(51) Int. Cl.: H01P 1/00, H01Q 1/28, H01Q 13/02, G01R 1/24, G01R 29/10, G01R 29/08

(54) **CONNECTION ADAPTER AND HORN ANTENNA MEASUREMENT DEVICE**
VERBINDUNGSADAPTER UND HORNANTENNENMESSVORRICHTUNG
ADAPTATEUR DE CONNEXION ET DISPOSITIF DE MESURE D'ANTENNE À CORNET

(43) Date of publication of application: 01.11.2023
(73) Proprietor: Institute for Q-shu Pioneers of Space, Inc., Fukuoka-shi Fukuoka 8100001 (JP)
(72) Inventor: UETSUHARA Masahiko, Fukuoka-shi, Fukuoka 810-0001 (JP); YAMAMOTO Daisuke, Fukuoka-shi, Fukuoka 810-0001 (JP); NOHMI Hitoshi, Mitaka-shi, Tokyo 181-0013 (JP)
(74) Representative: Pitchford, James Edward
(86) International application number: PCT/JP2020/048045
(87) International publication number: WO 2022/137364

(56) References cited:
- WO-A1-2017/221872
- JP-A- 2002 368 561
- JP-A- 2014 059 156
- US-A- 5 455 085
- US-A1- 2009 140 906
- US-A1- 2015 323 581
- RAHMAT-SAMII YAHYA ET AL: "Development of Highly Constrained 1 m Ka-Band Mesh Deployable Offset Reflector Antenna for Next Generation CubeSat Radars", IEEE TRANSACTIONS ON ANTENNAS AND PROPAGATION, IEEE, USA, vol. 67, no. 10, 1 October 2019 (2019-10-01), pages 6254 - 6266, XP011749126, ISSN: 0018-926X, [retrieved on 20191003], DOI: 10.1109/TAP.2019.2920223

## Description

### Technical Field

The present disclosure relates to a connection adapter and a horn antenna measurement device.

Hitherto, a spacecraft such as an artificial satellite on which various radars (antennas) including a synthetic aperture radar are mounted has been known (see Patent Literature 1). Here, it is necessary to grasp (measure or test) on the ground in advance whether high-frequency radio waves (and reflected waves thereof) radiated from an antenna mounted on the spacecraft, particularly a horn antenna, have desired characteristics (frequency) or the like.

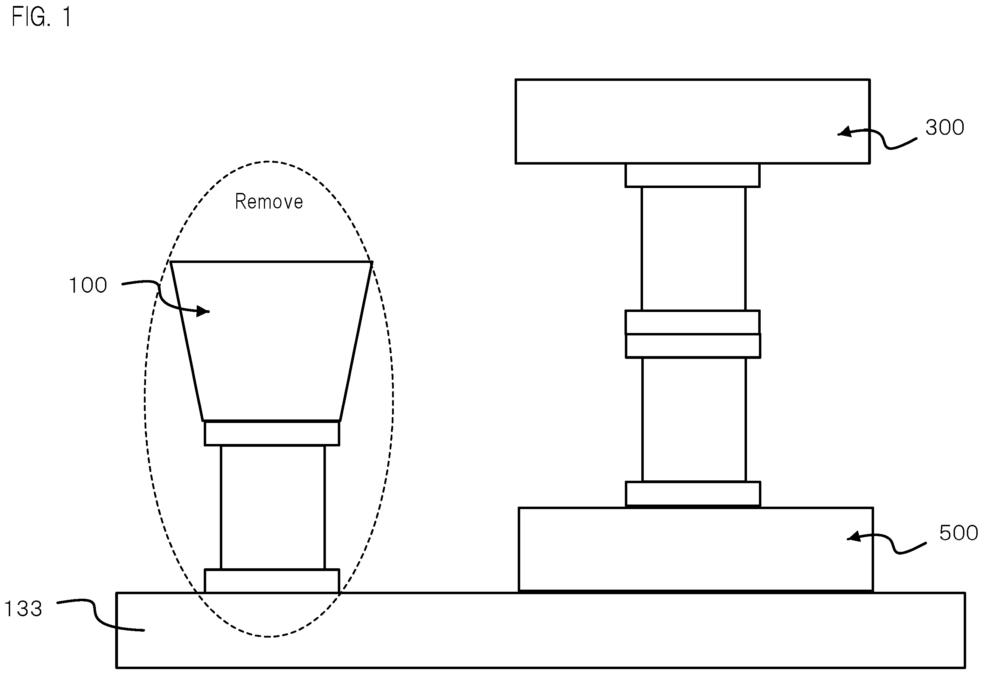

Such prior ground measurement or ground test needs to be performed in consideration of radio station license regulations, regulations for preventing radio frequency (RF) interference with surrounding equipment, and the like. Therefore, hitherto, as illustrated in Fig. 1, in order to measure or test the performance of a system of a horn antenna 100, it is usually necessary to separately connect a dedicated measurement system (a measurement unit 500, a measurement instrument 300, or the like) after removing the horn antenna 100. As a result, a transmitter 133 that oscillates radio waves on the horn antenna 100 and the measurement unit 500 are connected, and the ground measurement or ground test is performed after a measure for suppressing radio wave leakage into the air (external space) is separately taken.

### Citation List

### Patent Literature

Patent Literature 1: WO 2017/221872 A

### Summary of Invention

### Technical Problem

However, for example, in an artificial satellite, since it is substantially impossible to remove the hom antenna immediately before the launch where various components (instruments, parts, and the like) are fixed, there is a problem that the soundness of the system of the horn antenna immediately before the launch cannot be confirmed.

Therefore, according to various embodiments, there are provided a connection adapter and a horn antenna measurement device capable of measuring the performance of a system of a horn antenna on the ground without removing the horn antenna mounted on a spacecraft even immediately before the launch, while suppressing radio wave leakage to an external space.

### Solution to Problem

The present invention provides a connection adapter as defined in Claim 1 of the appended claims. Details of certain embodiments are set out in the dependent claims. Also provided is a horn antenna measurement device as defined in Claim 4.

A connection adapter according to one aspect includes a first waveguide that is provided inside the connection adapter and connected to a waveguide portion connected to a horn antenna, in which the connection adapter is detachably fitted into the horn antenna, is connected to a measurement instrument via a second waveguide coupled to the first waveguide, and guides radio waves radiated from the horn antenna to the measurement instrument in a closed system. This is an improvement over US 2009/140906 A1 which discloses a pick-up horn antenna mounted onto the aperture of a flight horn antenna, suppressing radio wave leakage to external space, while providing sensors and connectors to further measurement instruments for testing the flight horn antenna, but taking up additional space and volume.

In the connection adapter according to one aspect, a cross-sectional shape of one end of the first waveguide is the same as a cross-sectional shape of a radio wave opening end of the horn antenna, and a cross-sectional shape of the other end of the first waveguide is the same as a cross-sectional shape of the second waveguide.

In the connection adapter according to one aspect, a choke portion extending toward the inside of the connection adapter is formed on an outer surface of the connection adapter.

A horn antenna measurement device according to one aspect includes a horn antenna, a measurement instrument that measures radio waves radiated from the horn antenna, and a connection adapter that includes a first waveguide provided inside the connection adapter and connected to a waveguide portion connected to the horn antenna, is detachably fitted into the horn antenna, is connected to the measurement instrument via a second waveguide coupled to the first waveguide, and guides the radio waves radiated from the horn antenna to the measurement instrument in a closed system.

In the horn antenna measurement device according to one aspect, a cross-sectional shape of one end of the first waveguide is the same as a cross-sectional shape of a radio wave opening end of the horn antenna, and a cross-sectional shape of the other end of the first waveguide is the same as a cross-sectional shape of the second waveguide.

In the horn antenna measurement device according to one aspect, a choke portion extending toward the inside of the connection adapter is formed on an outer surface of the connection adapter.

### Advantageous Effects of Invention

According to various embodiments, it is possible to provide the connection adapter and the horn antenna measurement device capable of measuring the performance of a system of a horn antenna on the ground without removing the horn antenna mounted on a spacecraft even immediately before the launch, while suppressing radio wave leakage to an external space.

### Brief Description of Drawings

Fig. 1 is a schematic view schematically illustrating an example of a configuration of a horn antenna measurement device using a measurement unit according to the related art.
Fig. 2 is a schematic view schematically illustrating an example of a small synthetic aperture radar (SAR) satellite equipped with a horn antenna.
Fig. 3 is a schematic view schematically illustrating an example of a configuration of a horn antenna measurement device according to an embodiment.
Fig. 4 is a schematic perspective view schematically illustrating an example of a configuration of a connection adapter included in the horn antenna measurement device according to an embodiment.
Fig. 5 is a schematic perspective view schematically illustrating the example of the configuration of the connection adapter included in the horn antenna measurement device according to an embodiment.
Fig. 6A is a schematic cross-sectional view schematically illustrating a configuration of a modification of the connection adapter. Fig. 6B is an enlarged schematic cross-sectional view illustrating a region surrounded by a line with alternating long and short dashes in Fig. 6A.

### Description of Embodiments

Hereinafter, various embodiments of the present disclosure will be described with reference to the accompanying drawings. Additionally, components common in the drawings are denoted by the same reference signs. Further, it should be noted that components illustrated in a certain drawing may be omitted in another drawing for convenience of description. Furthermore, it should be noted that the accompanying drawings are not necessarily drawn to scale.

As used in the present disclosure, singular forms such as "a", "an", "one", "the", "above-described", "this", and the like may include plural forms unless such exclusion is explicitly stated. In addition, the term "includes" may mean "comprises".

### 1. Configuration of Horn Antenna Measurement Device According to Embodiment and Respective Elements Included in Device

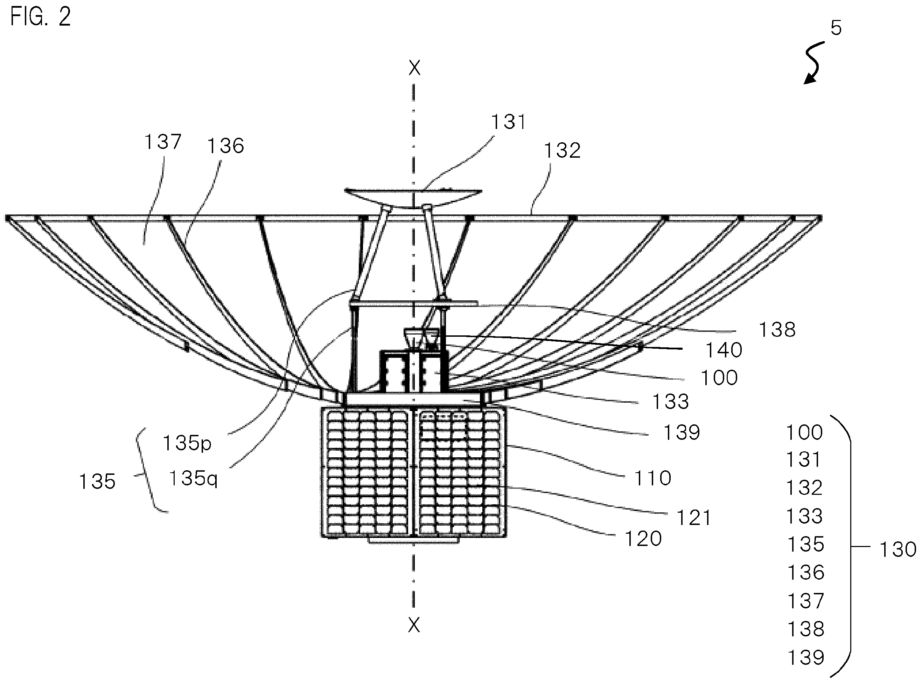

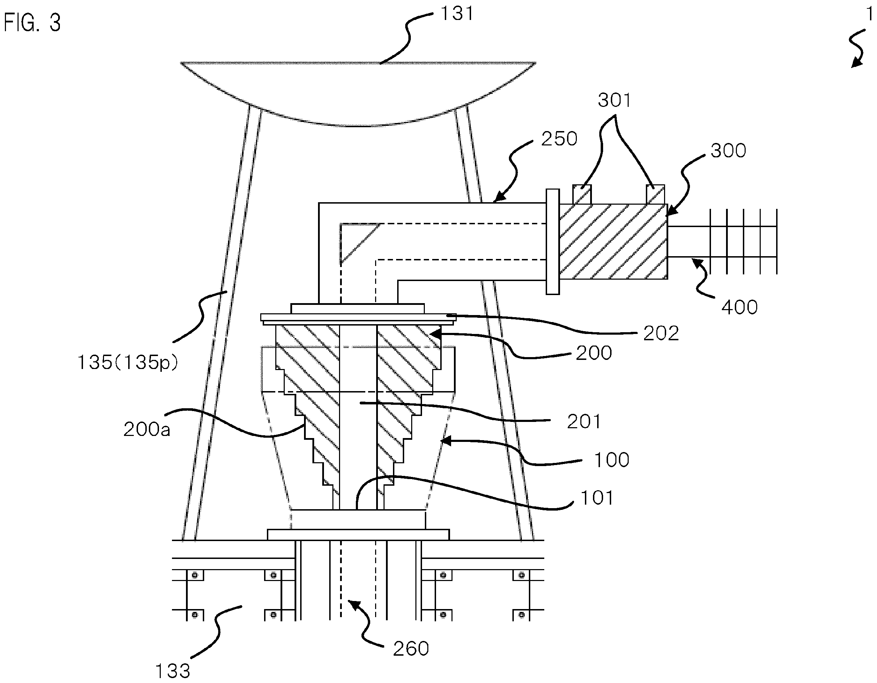

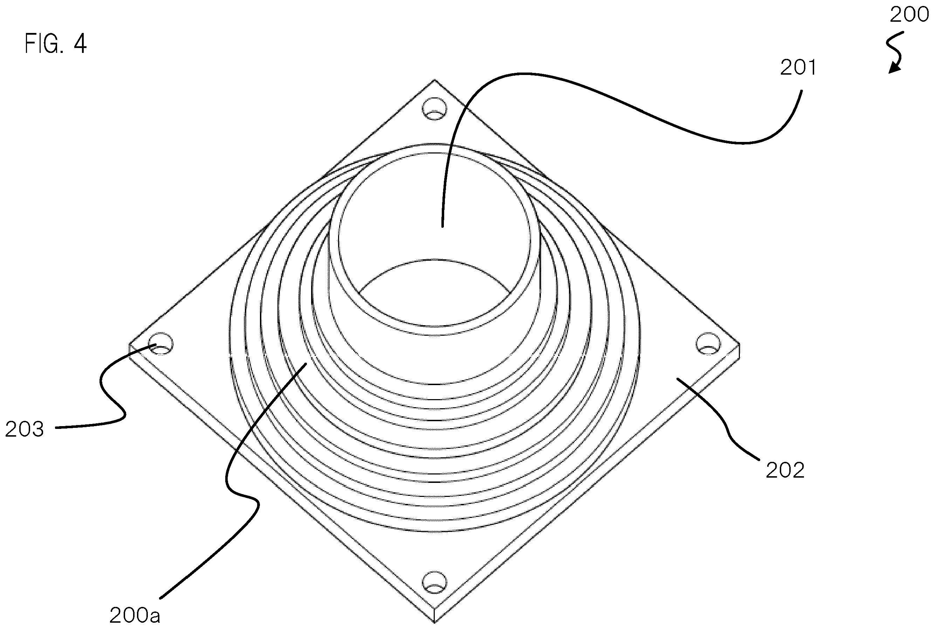

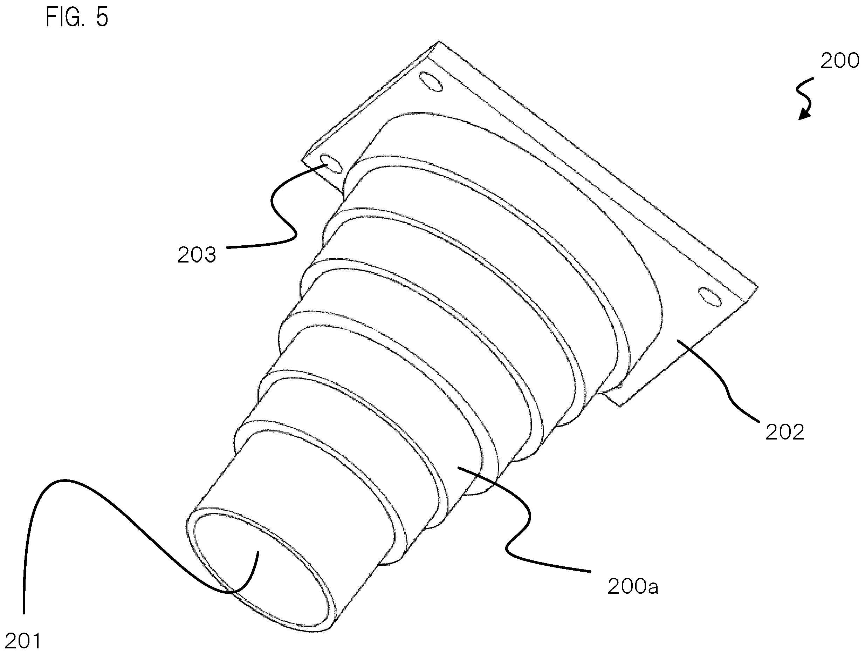

An overall configuration of a horn antenna measurement device according to an embodiment and an outline of each element included in a horn antenna measurement device 1 will be described with reference to Figs. 1 to 5. Fig. 1 is a schematic view schematically illustrating an example of a configuration of the horn antenna measurement device 1 using a measurement unit 20 according to the related art. Fig. 2 is a schematic view schematically illustrating an example of a small synthetic aperture radar (SAR) satellite 5 equipped with a horn antenna 100. Fig. 3 is a schematic view schematically illustrating an example of a configuration of a horn antenna measurement device 1 according to an embodiment. Figs. 4 and 5 are schematic perspective views schematically illustrating an example of a configuration of a connection adapter 200 included in the horn antenna measurement device 1 according to an embodiment.

As illustrated in Fig. 3, the horn antenna measurement device 1 mainly includes the horn antenna 100, a measurement instrument 300 that measures characteristics of radio waves radiated from the horn antenna, and the connection adapter 200 arranged between the horn antenna 100 and the measurement instrument 300. Hereinafter, details of each element included in the horn antenna measurement device 1 will be described.

### 1-1. Horn antenna 100 and spacecraft on which horn antenna 100 is mounted

As an example, the horn antenna 100 is mounted on a small synthetic aperture radar (SAR) satellite 5 as a spacecraft. Such a small SAR satellite 5 radiates radio waves in a microwave band, a millimeter wave band, or a sub-millimeter wave band to an observation target, and receives reflected waves from the observation target, so that observation, analysis, and the like of the observation target can be performed.

As illustrated in Fig. 2, the small SAR satellite 5 can mainly include a main body 110 on which instruments such as a control unit that performs control of navigation of the small SAR satellite 5 in space, control of an operation and posture of the small SAR satellite 5, and the like are mounted, a power supply unit 120 that supplies power for driving various components including the control unit and a communication unit in space, and a communication unit 130 that radiates radio waves toward space and receives radio waves from space.

The main body 110 can accommodate various electronic components (not illustrated) such as a computer, a sensor, an actuator, a power supply control circuit, a battery, and a communication control circuit.

The power supply unit 120 can include, for example, a battery, a charge/discharge control circuit, and the like (not illustrated). Examples of the battery can include a solar cell using a solar panel 121. The power supply unit 120 is connected to the main body 110 and the communication unit 130 and can supply power to each of the main body 110 and the communication unit 130.

The communication unit 130 mainly includes the horn antenna 100 as a radiator, a sub reflector (sub reflecting mirror) 131 that is arranged to face the horn antenna 100 at a predetermined angle and reflects radio waves radiated from the horn antenna 100 to a main reflector 132, the main reflector 132 as a main reflecting mirror that further reflects the radio waves reflected by the sub reflector 131 and radiates the radio waves to the outside, a transmitter 133, and support rods 135 for supporting the sub reflector 131.

As the horn antenna 100, a generally known horn antenna having a substantially trumpet shape (horn shape) whose opening area gradually increases toward the sub reflector 131 can be used. An inner portion of the horn antenna 100 has a shape in which a plurality of steps are formed as an example as illustrated in Fig. 3, but is not limited thereto. For example, the sub reflector 131 is illustrated as having a shape of a Cassegrain antenna in Fig. 3, but may be changed to a Gregorian antenna or the like.

The main reflector 132 includes a hub 139, a plurality of ribs 136, a planar body 137, and the like. The main reflector 132 has a reflection surface formed in a parabolic shape in order to function as the main reflecting mirror.

The hub 139 is provided on an antenna axis X at the center of the main reflector 132 and is provided on a side of the main body 110 where the sub reflector 131 is arranged. As an example, the hub 139 is formed in a substantially columnar shape by using a dielectric such as plastic or a metal material such as titanium or stainless steel. The plurality of ribs 136 are radially arranged at predetermined intervals on an outer peripheral surface of the hub 139 around the central axis X.

The ribs 136 include a plurality of ribs. The ribs 136 are arranged in a parabolic shape (radial shape) on the outer periphery of the hub 139 at predetermined intervals around the hub 139. The planar body 137 is bridged over the respective ribs 136 to form a reflecting mirror surface.

The sub reflector 131 is arranged to face the main reflector 132, and a lower surface side of the sub reflector 131 is supported by the support rod 135. The sub reflector 131 is arranged to be separated by a predetermined distance from the horn antenna 100 as the radiator arranged on the central axis X, by the support rod 135. Similarly to the planar body 137 of the main reflector 132, the sub reflector 131 is formed of a material capable of reflecting radio waves and has a quadratic curved surface shape as a whole toward a surface of the main reflector 132. The sub reflector 131 reflects radio waves radiated from the horn antenna 100 toward the main reflector 132.

The support rods 135 include a first support rod 135p having one end connected to the sub reflector 131 and the other end connected to a joint 138, and a second support rod 135q having one end connected to the joint 138 and the other end connected to the main body 110.

The transmitter 133 includes an oscillator, an amplifier, and the like (not illustrated), and amplifies radio waves having a frequency of a predetermined frequency band generated by the oscillator with the amplifier. The amplified radio waves are once reflected by the sub reflector 131 toward the main reflector 132 via the horn antenna as the radiator, and then radiated to the outside (for example, space) by the main reflector 132. Additionally, reflected waves received from the outside are received by a receiver included in the communication unit 130 through a reverse path.

The communication unit 130 can perform adjustment to radiate radio waves having an appropriate frequency, such as a frequency band of 8 GHz or less, a microwave band of 8 GHz to 12 GHz (so-called X band), a microwave band of 12 GHz to 18 GHz (so-called Ku band), a millimeter wave band of 30 GHz or more, or a sub-millimeter wave band of 300 GHz or more.

The communication unit 130 may also include an additional radiator 140 used for data transmission from the small SAR satellite 5 to a ground station (not illustrated). Similarly to the horn antenna 100, the radiator 140 can use a horn antenna, and is used for communication in a frequency band of 12 GHz to 18 GHz as an example.

The configuration of the small SAR satellite 5 described above is merely an example, and other components may be added as appropriate. In addition, the shape, the number, and the like of components described above can be appropriately changed.

### 1-2. Connection adapter 200

As illustrated in Fig. 3, the connection adapter 200 includes a first waveguide 201 provided therein and may thus guide radio waves radiated from the horn antenna 100 to the measurement instrument 300 to be described later via a second waveguide 250 coupled to the first waveguide 201 in a closed system (the radio waves radiated from the horn antenna 100 are not leaked to an external space). A cross-sectional shape of one end of the first waveguide 201 is the same as a cross-sectional shape of a radio wave opening end 101 of the horn antenna 100 (the radio wave opening end 101 of a waveguide portion 260 connected to the horn antenna 100). A cross-sectional shape of the other end of the first waveguide 201 is the same as a cross-sectional shape of the second waveguide 250.

Additionally, in a case where the cross-sectional shape of the radio wave opening end 101 where radio waves from the transmitter 133 that oscillates the radio waves are oscillated is different from the cross-sectional shape of the second waveguide 250 (for example, the cross-sectional shape of the radio wave opening end 101 is circular and the cross-sectional shape of the second waveguide 250 is rectangular), a waveguide converter (not illustrated) may be separately provided in the first waveguide 201 of the connection adapter 200 (alternatively, in the vicinity of the first waveguide 201, for example, upstream of the second waveguide 250).

As illustrated in Figs. 3 to 5, the connection adapter 200 has, as an example, an outer surface 200a having a shape corresponding to a shape of an inner wall of the horn antenna 100. That is, as illustrated in Fig. 3, in a case where the inner wall of the horn antenna 100 has a stepped shape having a plurality of steps as an example, the connection adapter 200 has the outer surface 200a having a stepped shape corresponding to the stepped shape. Thus, the connection adapter 200 can be detachably fitted into the inner wall of the horn antenna 100 without forming a substantial gap along the shape of the inner wall of the horn antenna 100. Additionally, as long as the connection adapter 200 is fixed to (fitted into) the horn antenna 100, the entire shape of the outer surface 200a of the connection adapter 200 does not necessarily correspond to the shape of the inner wall of the horn antenna 100. In other words, only a part of the outer surface 200a of the connection adapter 200 may correspond to the shape of the inner wall of the horn antenna 100.

In addition, the connection adapter 200 can have a plate portion 202 for connection with the second waveguide 250. The plate portion 202 is provided with a connection portion 203 for fixing the second waveguide 250 and the connection adapter 200, and the second waveguide 250 and the connection adapter 200 can be screwed via the connection portion 203.

The connection adapter 200 can be manufactured using, for example, a metal material such as aluminum.

### 1-3. Measurement Instrument 300

The measurement device 300 can measure the characteristics of radio waves radiated from the horn antenna 100, specifically, the power, the waveform, the phase, and the like. As a configuration and method of the measurement device 300, a known configuration and method (for example, a loopback test) can be used. Various pieces of information measured by the measurement device 300 are transmitted to a recording device, a calculation device (not illustrated), or the like via a coaxial cable (not illustrated) connected to a terminal 301 of the measurement device 300.

Additionally, a terminator 400 that attenuates radio waves radiated from the horn antenna 100 can be connected downstream of the measurement device 300.

The measurement instrument 300 and the above-described connection adapter 200 are connected by the second waveguide 250 having a predetermined length. The shape of the second waveguide 250 may be a straight line shape, or may be, for example, a bent shape bent in a substantially L shape as illustrated in Fig. 3.

As described above, the horn antenna measurement device 1 according to an embodiment including the respective elements can suppress radio wave leakage to an external space in a range from the horn antenna 100 to the measurement instrument 300 and efficiently measure the characteristics of radio waves by the measurement device 300 without removing the horn antenna 100 by using the connection adapter 200.

### 2. Modification

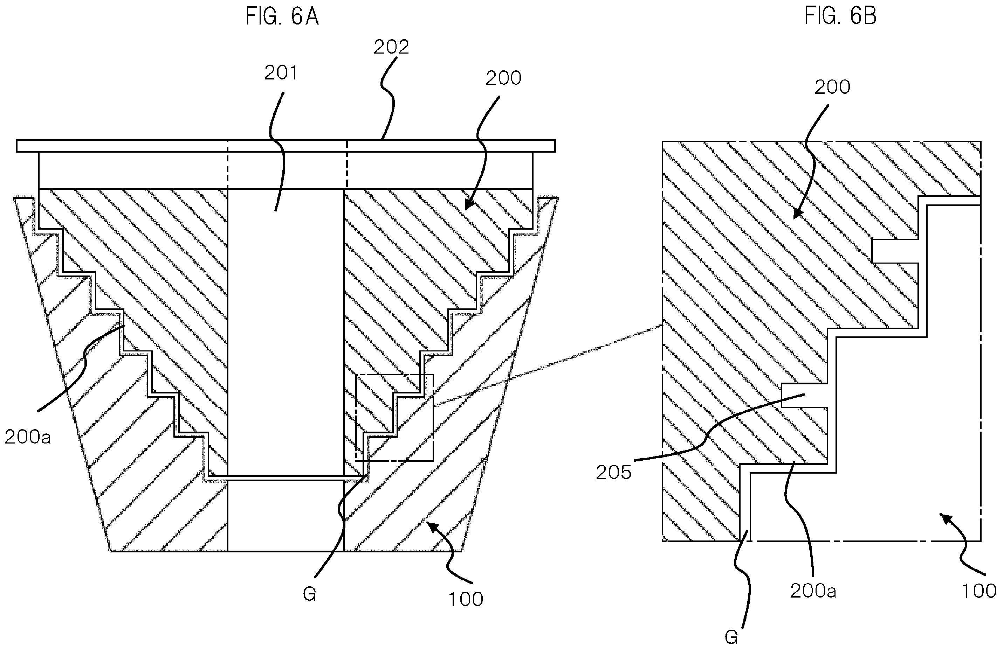

Next, a modification of the connection adapter 200 will be described with reference to Figs. 6A and 6B. Fig. 6A is a schematic cross-sectional view schematically illustrating a configuration of the modification of the connection adapter 200. Fig. 6B is an enlarged schematic cross-sectional view illustrating a region surrounded by a line with alternating long and short dashes in Fig. 6A.

In order to more efficiently suppress leakage of radio waves radiated from the horn antenna 100 to an external space, a choke portion 205 is formed in the connection adapter 200 according to the modification as illustrated in Fig. 6B. As illustrated in Figs. 6A and 6B, the choke portion 205 is formed on the outer surface 200a of the connection adapter 200 that faces the horn antenna 100 and has a cutout shape extending toward the inside of the connection adapter 200.

As a result, even in a case where a slight gap G is formed between the connection adapter 200 and the inner wall of the horn antenna 100, it is possible to attenuate traveling waves by forming reflected waves at the choke portion 205 when the radio waves travel through the gap. Therefore, it is possible to more efficiently suppress radio wave leakage to an external space.

As described above, various embodiments have been exemplified, but the embodiments are merely examples, and are not intended to limit the scope of the invention as defined in the appended claims. The embodiments can be implemented in various other forms, and various omissions, substitutions, and changes can be made without departing from the scope of the appended claims. **In** addition, the horn antenna 100 described above is not limited to a case of being used for observation, analysis, and the like of an observation target, and may be used, for example, for downlink for imaging data and the like from the small SAR satellite 5.

### Reference Signs List

- 1: horn antenna measurement device
- 5: spacecraft (small SAR satellite)
- 100: horn antenna
- 200: connection adapter
- 201: first waveguide
- 205: choke portion
- 250: second waveguide
- 260: waveguide portion
- 300: measurement instrument

## Claims

1. A connection adapter (200) comprising
a first waveguide (201) that is provided inside the connection adapter (200) and connected to a waveguide portion (260) connected to a horn antenna (100),
wherein the connection adapter (200) is detachably fitted into the horn antenna (100), is connected to a measurement instrument (300) via a second waveguide (250) coupled to the first waveguide (201), and guides radio waves radiated from the horn antenna (100) to the measurement instrument (300) in a closed system.

2. The connection adapter according to claim 1, wherein a cross-sectional shape of one end of the first waveguide (201) is the same as a cross-sectional shape of a radio wave opening end (101) of the horn antenna (100), and a cross-sectional shape of the other end of the first waveguide (201) is the same as a cross-sectional shape of the second waveguide (250).

3. The connection adapter according to claim 1 or claim 2, wherein a choke portion (205) extending toward an inside of the connection adapter (200) is formed on an outer surface (200a) of the connection adapter (200).

4. A horn antenna measurement device (1) comprising:
the connection adapter (200) according to any of claims 1 to 3;
the horn antenna (100); and
the measurement instrument (300) that measures radio waves radiated from the horn antenna (100).

## Patentansprüche

1. Verbindungsadapter (200), Folgendes umfassend:
einen ersten Wellenleiter (201), der im Inneren des Verbindungsadapters (200) bereitgestellt und mit einem Wellenleiterabschnitt (260) verbunden ist, der mit einer Hornantenne (100) verbunden ist,
wobei der Verbindungsadapter (200) lösbar in die Hornantenne (100) eingebaut ist, über einen mit dem ersten Wellenleiter (201) gekoppelten zweiten Wellenleiter (250) mit einem Messinstrument (300) verbunden ist und von der Hornantenne (100) abgestrahlte Funkwellen in einem geschlossenen System zu dem Messinstrument (300) leitet.

2. Verbindungsadapter nach Anspruch 1, wobei eine Querschnittsform eines Endes des ersten Wellenleiters (201) dieselbe ist wie eine Querschnittsform eines Funkwellenöffnungsendes (101) der Hornantenne (100) und eine Querschnittsform des anderen Endes des ersten Wellenleiters (201) dieselbe ist wie eine Querschnittsform des zweiten Wellenleiters (250).

3. Verbindungsadapter nach Anspruch 1 oder Anspruch 2, wobei ein Drosselabschnitt (205), der sich zu einer Innenseite des Verbindungsadapters (200) hin erstreckt, an einer äußeren Oberfläche (200a) des Verbindungsadapters (200) ausgebildet ist.

4. Hornantennenmessvorrichtung (1), die Folgendes umfasst:
den Verbindungsadapter (200) nach einem der Ansprüche 1 bis 3;
die Hornantenne (100); und
das Messinstrument (300), das die von der Hornantenne (100) abgestrahlten Funkwellen misst.

## Revendications

1. Adaptateur de connexion (200) comprenant
un premier guide d'ondes (201) qui est prévu à l'intérieur de l'adaptateur de connexion (200) et connecté à une portion de guide d'ondes (260) connectée à une antenne à cornet (100),
où l'adaptateur de connexion (200) est monté de manière détachable dans l'antenne à cornet (100), est connecté à un instrument de mesure (300) par l'intermédiaire d'un deuxième guide d'ondes (250) couplé au premier guide d'ondes (201), et guide des ondes radio rayonnées à partir de l'antenne à cornet (100) jusqu'à l'instrument de mesure (300) dans un système fermé.

2. Adaptateur de connexion selon la revendication 1, où une forme en coupe transversale d'une extrémité du premier guide d'ondes (201) est la même qu'une forme en coupe transversale d'une extrémité d'ouverture d'ondes radio (101) de l'antenne à cornet (100), et une forme en coupe transversale de l'autre extrémité du premier guide d'ondes (201) est la même qu'une forme en coupe transversale du deuxième guide d'ondes (250).

3. Adaptateur de connexion selon la revendication 1 ou la revendication 2, où une portion de bobine d'arrêt (205) s'étendant vers un espace interne de l'adaptateur de connexion (200) est formée sur une surface externe (200a) de l'adaptateur de connexion (200).

4. Dispositif de mesure d'antenne à cornet (1) comprenant :
l'adaptateur de connexion (200) selon n'importe lesquelles des revendications 1 à 3 ;
l'antenne à cornet (100) ; et
l'instrument de mesure (300) qui mesure des ondes radio rayonnées à partir de l'antenne à cornet (100).
